## Europäisches Patentamt

## European Patent Office

## Office européen des brevets

(11) Publication number: **0 144 218**
**B1**

(12) **EUROPEAN PATENT SPECIFICATION**

(45) Date of publication of patent specification: **05.09.90**

(21) Application number: **84308308.0**

(22) Date of filing: **29.11.84**

(51) Int. Cl.⁵: **H 03 K 19/177, H 03 K 19/086**

(54) **ECL Gate array.**

(30) Priority: **30.11.83 JP 225629/83**
**16.12.83 JP 238555/83**
**16.12.83 JP 238556/83**

(43) Date of publication of application:
**12.06.85 Bulletin 85/24**

(45) Publication of the grant of the patent:
**05.09.90 Bulletin 90/36**

(84) Designated Contracting States:
**DE FR GB**

(56) References cited:
**GB-A-2 110 029**
**US-A-3 700 915**

**IBM TECHNICAL DISCLOSURE BULLETIN, vol.
19, no. 10, March 1977, pages 3736,3737, New
York, US; H.D. VARADARAJAN: "Programmable
swing current switch for low-power high-speed
circuits"**

(73) Proprietor: **FUJITSU LIMITED**
**1015, Kamikodanaka Nakahara-ku**
**Kawasaki-shi Kanagawa 211 (JP)**

(72) Inventor: **Kanai, Yasunori**
**536-5-2-401 Oomaru Inagi-shi**
**Tokyo 206 (JP)**
Inventor: **Nawata, Kazumasa**
**22-32-204 Nishiikuta 5-chome Tama-ku**
**Kawasaki-shi**
**Kanagawa 214 (JP)**
Inventor: **Shimizu, Mitsuhisa**
**Inoue-so 2-A 5-5-5 Suge Tama-ku Kawasaki-shi**
**Kanagawa 214 (JP)**

(74) Representative: **Fane, Christopher Robin King
et al**
**HASELTINE LAKE & CO. Hazlitt House 28
Southampton Buildings Chancery Lane
London, WC2A 1AT (GB)**

Courier Press, Leamington Spa, England.

# EP 0 144 218 B1

(56) References cited:

IEEE JOURNAL OF SOLID-STATE CIRCUITS, vol. SC-18, no. 5, October 1983, pages 585-592, IEEE, New York, US; M. SUZUKI et al.: "A 5K-gate bipolar masterslice LSI with a 500 ps loaded gate delay"

PATENTS ABSTRACTS OF JAPAN, vol. 8, no. 8 (E-221)1445r, 13th January 1984; & JP-A-58 172 021 (NIPPON DENKI K.K.) 08-10-1983

PATENTS ABSTRACTS OF JAPAN, vol. 5, no. 44 (E-50)716r, 24th March 1981; & JP-A-56 745 (MITSUBISHI DENKI K.K.) 07-01-1981

ELECTRO/80 CONFERENCE RECORD, Boston, MA, US, 13th-15th May 1980, vol. 5, no. 22/1, April 1980, Los Angeles, US; T. GOODMAN: "F300 advanced gate array offering power/delay tradeoffs"

REVIEW OF THE ELECTRICAL COMMUNICATION LABORATORIES, vol. 26, no. 9/10, September/October 1978, pages 1325-1338, Tokyo, JP; H. MUKAI et al.: "Master slice ECL LSI"

PATENTS ABSTRACTS OF JAPAN, vol. 1, no. 58, 6th June 1977, page 37 E 77; & JP-A-52 2161 (HITACHI SEISAKUSHO K.K.) 08-01-1977

## Description

The present invention relates to an emitter-coupled logic (ECL) gate array.

Various approaches have been made toward improving the performance of an ECL gate array by improving its noise margin or switching speed, but these approaches have not resolved all of the problems to be found in ECL gate arrays.

In a conventional ECL gate array, resistors for determining the logical levels, i.e. a high logic level and a low logic level of each basic cell, have fixed resistance values, which can result in a deteriorated noise margin in some basic cells in an ECL gate array. For example, when a basic cell is arranged too far from a power supply pad, the power supply voltage applied to the basic cell drops because of the length of the power supply line. Therefore, both the high logic level and the low logic level of such a basic cell are lowered, and such a lowered high logic level may be erroneously detected by the next stage basic cell as a normal low logic level.

Further, when a basic cell has two output transistors connected in parallel, to shorten the rising time of the voltage at its output end, the levels of the output high and low logic levels are raised, as later described in more detail with reference to the drawings, and the thus raised low logic level may be erroneously detected by the next stage basic cell as a high logic level.

Still further, when a basic cell has two output resistors connected in parallel, to shorten the falling time of the voltage at its output end, the levels of the output high and low logic levels are lowered, as later described in more detail, and the thus lowered high logic level may be erroneously detected by the next stage basic cell as a low logic level.

Furthermore, when an ECL gate array includes a sequential circuit, the output levels of its previous stage basic cells should have a particularly improved noise margin since the internal state of a sequential circuit depends on the immediately preceding input values. Therefore, it is necessary to change the output logic levels of the above-mentioned previous stage basic cells. However, in the conventional ECL gate array, it is impossible to change the output logic levels of only the above-mentioned previous stage basic cells without changing the output logic levels of remaining basic cells.

Generally, when performing a high switching operation, the logic swing between the low logic level and the high logic level is increasingly reduced, and thus the above-mentioned cases of erroneous detection become more significant.

In another conventional ECL gate array (as disclosed in Japanese Unexamined Patent Publication (Kokai) No. 53-60554, laid open—on May 31, 1978, filed by Inventors: Yutaka Hara et al and Applicant: Hitachi Ltd), a basic cell capable of switching between a large logic swing and a small logic swing is disclosed. However, this conventional basic cell has a disadvantage of a low switching speed due to parasitic capacitances, as later described in more detail with reference to a drawing.

Accordingly, it is desirable to provide an ECL gate array which can overcome the above-mentioned problems.

According to an embodiment of the present invention there is provided an ECL gate array comprising a plurality of basic cells arranged in a matrix and each connected between first and second power supply lines, each of the said basic cells comprising at least a pair of emitter-coupled transistors, a load connected between respective collectors of the transistor pair and the first power supply line, current source means connected between the coupled emitters of the said transistor pair and the said second power supply line, and an output node connected to the collector of one of the said transistors of the said pair; the said basic cells of the said plurality being connected together in accordance with a desired wiring pattern, and the said load comprising a first load resistor connected between the collector of one of the said transistors and a common anode, a second load resistor connected between the collector of the other of the said transistors and the said common node, and resistance means connected between the said common node and the said first power supply line;

characterised in that in each basic cell the said resistance means comprise a group of level-shifting resistors which have been selected from a plurality of level-shifting resistors provided in the cell concerned and are connected together to provide a desired load in accordance with the said wiring pattern, and in that the current source means of at least one basic cell in the array provide substantially the same current as the current source means of another of the said basic cells, the said group of level-shifting resistors in the said one basic cell being chosen in such a way that the load provided thereby differs from that of the said another basic cell, thereby to ensure that the amplitude of an output signal appearing at the said output node of the said one basic cell is substantially equal to the amplitude of an output signal appearing at the output node of the said another basic cell.

Thus, in an ECL gate array embodying the present invention, each basic cell has a plurality of level-shifting resistors at least some of which are connected together so as to provide a desired load, thereby enabling required values of the high and low levels of the output signal to be obtained without changing the amplitude of the logic swing.

A basic cell suitable for use in an ECL gate array is disclosed in US-3,700,915. This known basic cell comprises a pair of emitter-coupled transistors, a load connected between respective collectors of the transistor pair and a first power supply line, current source means connected between the coupled emitters of the said transistor pair and a second power supply line, and an output node connected to the collector of one of the transistors of the pair. The collector load comprises a first load resistor connected between the collector of one of the transistors and a common node, a second load resistor connected between the collector of the other transistor and the common node, and resistance means connected between the common node and the first power supply line. The resistance means in the basic cell known from US-3,700,915 consist of a coupling resistor and an optional metallization shunting which is arranged such that it can be connected across the coupling resistor so as to short-circuit the path between the common node and the first power supply line. Similarly, in this known basic cell an optional meallization shunting is arranged such that it can be connected across a resistor constituting the current source means so as to short-circuit the path between the coupled emitters and the second power supply line. These shuntings are provided so as to enable the cell to be used as either a full-power gate, when the shuntings are connected, or as a half-power gate, when they are not. Although the logic swing at the output node in each case is about the same reference level, it is in the former case of much larger amplitude than in the latter. In this respect, US-3,700,915 does not address the problems with which the present application is concerned and, furthermore, contains no suggestion as to how those problems may be solved, particularly in view of the fact that it teaches a technique which results in a change in the amplitude of the logic swing.

Another prior art basic cell, which is disclosed in IBM Technical Disclosure Bulletin, Volume 19, No. 10, pages 3736 and 3737, employs, instead of the above-mentioned first and second resistors and the resistance means, a pair of variable resistors connected respectively between individual collectors of the emitter-coupled transistors and a power supply line. The variable resistors are connected by means of a conductive link, the position of which may be altered so as to change the load provided by those resistors. This, like the cell proposed in US-3,700,915, also results in an undesirable change in the amplitude of the logic swing.

Reference will now be made, by way of example, to the accompanying drawings, wherein:

Figure 1 shows a general plan view of a conventional ECL gate array;

Figure 2 is a circuit diagram illustrating a conventional basic cell in an ECL gate array;

Figure 3 is a waveform diagram explaining the operation of the basic cell shown in Figure 2;

Figure 4 is a circuit diagram illustrating another conventional basic cell in an ECL gate array;

Figure 5 is a circuit diagram illustrating a basic cell in an ECL gate array embodying the present invention;

Figure 6 is a circuit diagram illustrating two basic cells in an ECL gate array embodying the present invention;

Figure 7 is a circuit diagram illustrating another basic cell in an ECL gate array embodying the present invention;

Figure 8 is a circuit diagram illustrating a further basic cell in an ECL gate array embodying the present invention;

Figure 9 is a logic circuit diagram including a sequential circuit in an ECL gate array embodying the present invention;

Figure 10 is a circuit diagram illustrating the circuit shown in Figure 9 in more detail;

Figure 11 is a circuit diagram illustrating yet another basic cell in an ECL gate array embodying the present invention;

Figure 12 is a circuit diagram illustrating still another basic cell in an ECL gate array embodying the present invention; and

Figure 13 is a plan view illustrating a wiring pattern in the basic cell shown in Figure 12.

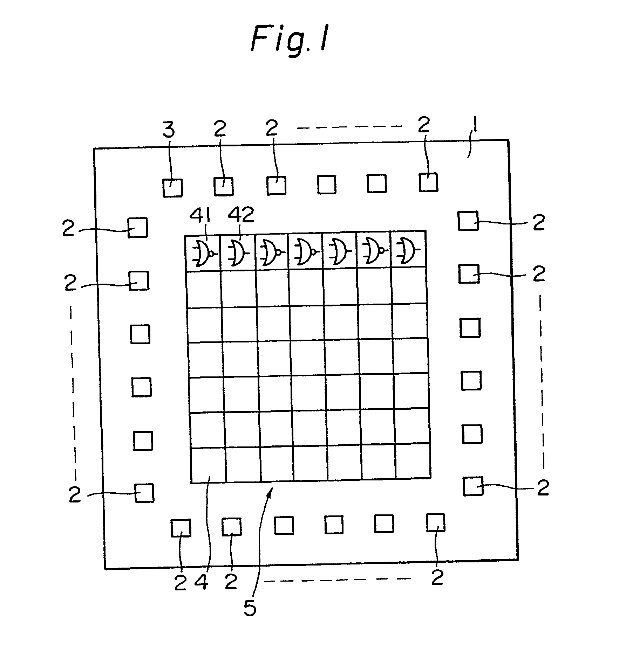

Figure 1 is a general plan view of a conventional ECL gate array. In Figure 1, a number of input/output pads 2 and a power supply pad 3 are arranged on the periphery of a semiconductor chip 1, and a plurality of basic cells 4 are arranged in a matrix 5 on the central portion of the semiconductor chip 1. Each of these basic cells is an ECL gate functioning, for example, as a NOR gate 41 or as an OR gate 42.

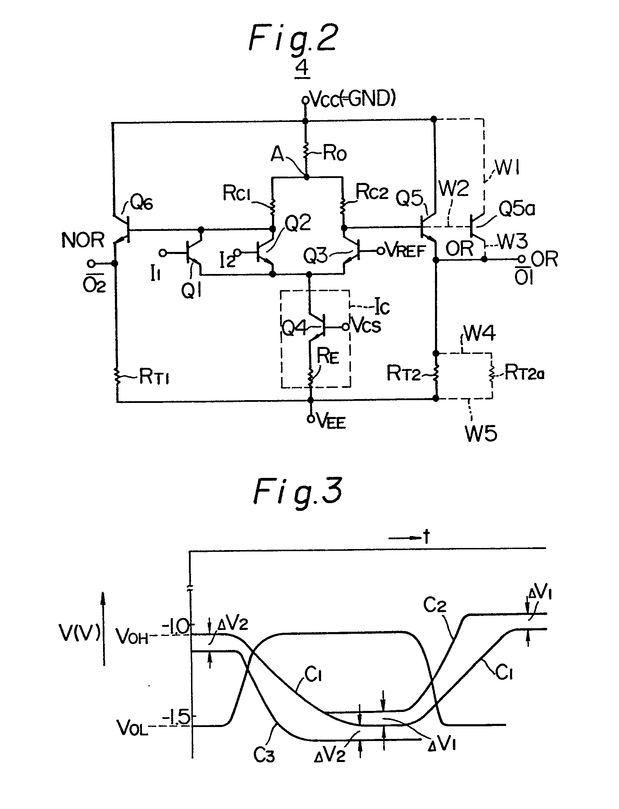

Figure 2 is a circuit diagram illustrating one of the conventional basic cells 4 shown in Figure 1. In Figure 2, the conventional basic cell 4 includes input transistors Q1 and Q2 for receiving input signals $I_1$ and $I_2$ at their respective basis, a reference transistor Q3 for receiving a reference voltage $V_{REF}$ at its base, a constant current source $I_C$ consisting of a transistor Q4 and a resistor $R_E$, a first output transistor Q5, and a second output transistor Q6. The input transistors Q1 and Q2 and the reference transistor Q3 are emitter coupled. A first load resistor $R_{C1}$ is connected between the collectors of the input transistors Q1 and Q2 and a common connecting point or node A. A second load resistor $R_{C2}$ is connected between the collector of the reference transistor Q3 and the common connecting point A. A common load resistor $R_0$ is connected between the common connecting point A and a ground voltage power supply line $V_{CC}$. $R_{T1}$ and $R_{T2}$ are output resistors.

In the basic cell shown in Figure 2, a logical OR is obtained at a first output end $\bar{O}_1$, and a logical NOR is obtained at a second output end $\bar{O}_2$. The logic swing between a high logic level and a low logic level at the output end $\bar{O}_1$ or $\bar{O}_2$ is fixed for all of the basic cells because the resistors $R_0$, $R_{C1}$, $R_{C2}$, and $R_E$, respectively, have predetermined fixed resistance values, and the voltages $V_{REF}$ and $V_{CS}$ are also predetermined fixed voltage values.

Since the logic swing is fixed, problems arise in the conventional basic cell. For example, when the basic cell is arranged so as to be remote from the power supply pad 3 (see Figure 1), a voltage drop through the power supply line $V_{cc}$, or through a negative-voltage power supply line $V_{EE}$, becomes significantly large. Therefore the high logic level and the low logic level at the output end $\bar{O}_1$ or $\bar{O}_2$ are lowered in comparison with respective normal high and low logic levels, such as those found at the output ends of a basic cell situated closer to the power source. The lower high logic level may be erroneously detected by the next stage basic cell as a low logic level. Accordingly, the noise margin of the basic cell is decreased in this case, especially for the high logic level.

In another example, two output transistors are often connected in parallel to shorten the rising time of the logic level at the output end. In Figure 2, dash lines W1, W2 and W3 show the additional wirings for connecting an additional output transistor Q5a in parallel with the output transistor Q5. In this case, since the two output transistors Q5 and Q5a drive a load (not shown), connected to the output end $\bar{O}_1$, the driving capability is increased, or the burden of each output transistor Q5 or Q5a is decreased, in comparison with the case where a single output transistor is employed. Thus, the rising time is shortened, as shown in Figure 3, by a curve C2 in comparison with a curve C1; where the curve C2 represents the output waveform when the two output transistors Q5 and Q5a are connected, and the curve C1 represents the output waveform when only the single output transistors Q5 is employed.

However, when the two output transistors are employed, the emitter current of each output transistor is decreased in comparison with the case when the single output transistor is employed. Therefore, the base-emitter voltage is decreased, and accordingly, both the high logic level and the low logic level at the output end $\bar{O}_1$ are increased by $\Delta V_1$, as shown in Figure 3. When the logic swing at the output end $\bar{O}_1$ is designed to be 500 mV, the increased value $\Delta V_1$ reaches the range of about 30 mV through 40 mV. The thus increased low logic level $V_{01}+\Delta V_1$ may be erroneously detected as a high logic level by the next stage basic cell.

In still another example, two output resistors are often connected in parallel to shorten the falling time of the logic level at the output end. In Figure 2, dash lines W4 and W5 show the additional wirings for connecting an additional output resistor $R_{T2a}$ in parallel with the output resistor $R_{T2}$. Assuming that the additional output transistor Q5a is not connected to the basic cell 4, then in this case, since the emitter current of the transistor Q5 is increased in comparison with the case where the additional resistor $R_{T2a}$ is not connected, the base-emitter voltage and the base current of the output transistor Q5 are also increased. Accordingly, both the high logic level and the low logic level at the output end $\bar{O}_1$ are decreased by $\Delta V_2$, as shown in Figure 3. When the logic swing at the output end $\bar{O}_1$ is designed to be 500 mV, the decreased value $\Delta V_2$ is also in the range of about 30 mV through 40 mV. Thus, the decreased high logic level $V_{0H}-\Delta V_2$ may be erroneously detected as a low logic level by the next stage basic cell.

The above-mentioned shift of the logic swing causes a decrease of the noise margin, especially when the logic swing is decreased to increase the switching speed. This noise margin is particularly important when the next stage of the basic cell is a sequential circuit.

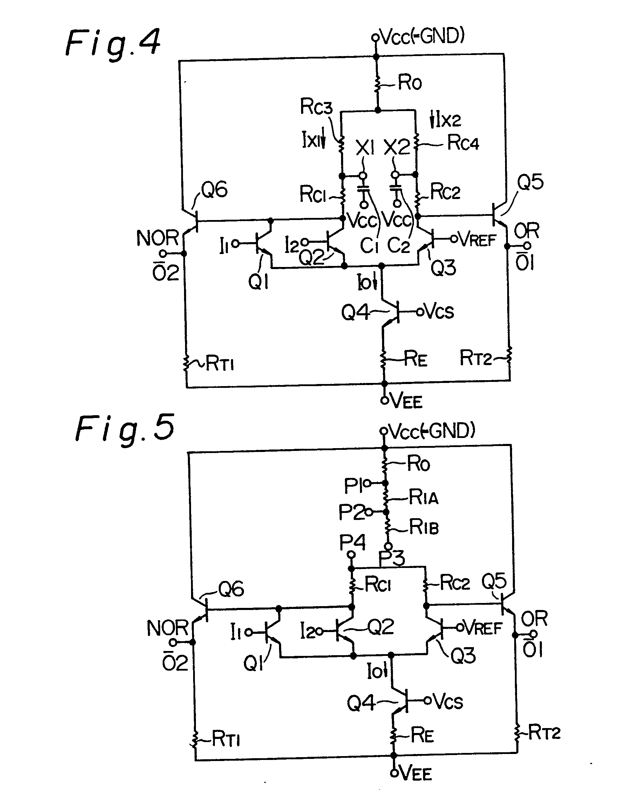

In the above-mentioned conventional basic cell, the logic swing is fixed. However, Figure 4 shows another example of a conventional basic cell in which the logic swing can be changed without changing the threshold level. In Figure 4, when terminals X1 and X2 are short-circuited, a small logic swing is obtained, and when the terminals X1 and X2 are not connected, a large logic swing is obtained. In the small logic swing and the large logic swing, the threshold voltage is constant but the noise margin is naturally increased by the large logic swing.

There is, however, a disadvantage in the basic cell shown in Figure 4. That is, the terminals X1 and X2 are positioned in current paths including resistors $R_{c3}$ and $R_{c1}$, and resistors $R_{c4}$ and $R_{c2}$, respectively. The currents $I_{x1}$ and $I_{x2}$ flowing through the current paths are changed in response to the switching operation of the basic cell. For example, when the input transistor $Q_1$ or $Q_2$ is in an ON state, and when the reference transistor Q3 is in an OFF state, the current $I_{x1}$ flowing through the resistors $R_{c3}$ and $R_{c1}$ is large, and the current flowing through the resistors $R_{c4}$ and $R_{c1}$ is small. When the input transistors Q1 and Q2 are turned off, and the reference transistor Q3 is turned on, the current $I_{x1}$ becomes small and the current $I_{x2}$ becomes large. Accordingly, the currents $I_{x1}$ and $I_{x2}$ at the terminals $X_1$ and $X_2$ are always changed in response to the switching operation. Thus, parasitic capacitors C1 and C2, naturally present between the terminals X1 and X2 and the power supply line $C_{cc}$, always effect a charge and discharge operation in response to the switching operation of the basic cell. This charge and discharge operation reduces the switching speed of the basic cell.

The preferred embodiments of the present invention will now be described with reference to Figures 5 to 13.

Figure 5 shows a basic cell for an ECL gate array embodying the present invention. In Figure 5, and in the other drawings, the same reference symbols indicate the same parts or portions as those in the conventional circuits shown in Figures 2 and 3. The main feature in the circuit shown in Figure 5 resides in the provision of additional resistors $R_{1A}$ and $R_{1B}$, first, second, and third selecting terminals P1 through P3, and a common connecting terminal or node P4 in place of the common connecting terminal A in the conventional basic cell. The other portions are the same as those in the conventional basic cell shown in Figures 2 and 4.

The resistors $R_0$, $R_{1A}$, and $R_{1B}$, i.e. common collector resistors, are connected in series between the ground-voltage power supply line $V_{cc}$ and the third selecting terminal P3. The common collector resistors $R_0$, $R_{1A}$, and $R_{1B}$ are used to shift the voltage level at the collectors of the transistors Q1, Q2, and Q3. Therefore, the

resistors $R_0$, $R_{1A}$, and $R_{1B}$ will sometimes be referred to hereafter as level-shifting resistors. The resistors $R_0$ and $R_{1A}$ constitute a standard resistor having a standard resistance value. The first selecting terminal P1 is connected to a common connecting point or node between the resistors $R_0$ and $R_{1A}$. The second selecting terminal P2 is connected to a common connecting point or node between the resistors $R_{1A}$ and $R_{1B}$. The third selecting terminal P3 is connected to the other end of the resistor $R_{1B}$. The resistance values of the additional resistors $R_{1A}$ and $R_{1B}$ lie in the range from about 0.1 $R_0$ to 0.2 $R_0$, where $R_0$ represents the resistance of the resistor $R_0$.

In accordance with the wiring pattern which is to be followed so as to form a desired integrated circuit (IC) including the ECL gate array, the common connecting terminal P4 is connected to one of the selecting terminals P1 through P3. For example, in normal usage, the common connecting terminal P4 is connected to the second selecting terminal P2 in such a manner that the resistors $R_0$ and $R_{1A}$ constitute a common collector load. When the noise margin of the high voltage level at the output end $\bar{O}_1$ or $\bar{O}_2$ may be increased, the common connecting terminal P4 is connected to the first selecting terminal P1 so that only the resistor $R_0$ constitutes a common collector load having a smaller resistance value than that formed in the normal usage by two resistors $R_0$ and $R_{1A}$. Where the noise margin of the low voltage level at the output end $\bar{O}_1$ or $\bar{O}_2$ ay be increased, the common connecting terminal P4 is connected to the third selecting terminal P3 so that the three resistors $R_0$, $R_{1A}$, and $R_{1B}$ constitute a common collector load having a larger resistance value than that formed in the normal usage by the two resistors $R_0$ and $R_{1A}$.

In all of the above cases, assuming that the voltage at the common connecting terminal is $V_{P4}$, which varies in dependence upon whether the terminal P4 is connected to the terminal P1, P2 or P3, then the high logic level $V_{OH}$ and the low logic level $V_{OL}$ at the output end $\bar{O}_1$ can be expressed as:

$$V_{OH} = V_{P4} - V_{BEQ5} - I_{BQ5} \cdot R_{C2}$$
$$V_{OL} = V_{P4} - V_{BEQ5} - (I_{BQ5} + \alpha_1 I_0) R_{C2}$$

where $V_{BEQ5}$ is the base-emitter voltage of the transistor $Q_5$; $I_{BQ5}$ is the base current of the transistor $Q_5$, $\alpha_1$ is a ratio between the collector current and the emitter current of the reference transistor Q3; and $R_{C2}$ is the resistance value of the second load resistor $R_{C2}$.

For the output end $\bar{O}_2$, the high logic level and the low logic level can also be expressed by similar expressions, i.e.

$$V_{OH} = V_{P4} - V_{BEQ6} - I_{BQ6} \cdot R_{C1}$$
$$V_{OL} = V_{P4} - V_{BEQ6} - (I_{BQ6} + \alpha_2 I_0) R_{C1}$$

The voltage $V_{P4}$ can be changed by connecting the common connecting terminal P4 to different ones of the selecting terminals P1 through P3.

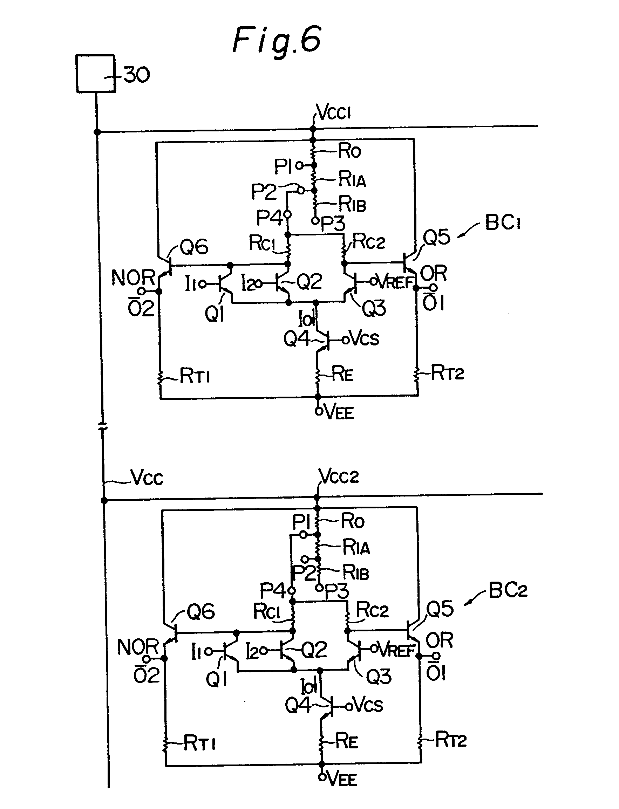

Figure 6 shows two basic cells $BC_1$ and $BC_2$ in an ECL gate array embodying the present invention. The first basic cell $BC_1$ is arranged at a position which is comparatively close to a power supply pad 30 on a chip of the ECL gate array. The position of the second basic cell $BC_2$ is, however, comparatively remote from the power supply pad 30. Thus, because of the greater length of the power supply line $V_{CC}$ from the power supply pad 30 to the second basic cell $BC_2$, the voltage at the power supply terminal $V_{CC2}$ for that cell is considerably lower than the power supply voltage applied to the power supply pad 30, owing to a voltage drop through the power supply line between the power supply pad 30 and the power supply terminal $V_{CC2}$. Therefore, the high logic level and the low logic level at the output end $O_1$ of the second basic cell $BC_2$ are lower than those at the output end of the first basic cell $BC_1$.

To compensate for the lowered high logic level in the second basic cell $BC_2$, the first selecting terminal P1 is connected to the common connecting terminal P4. In comparison, in the first basic cell $BC_1$ the second selecting terminal P2 is connected to the common connecting terminal P4, because it is not necessary to raise or lower the output logic level in relation to a standard level.

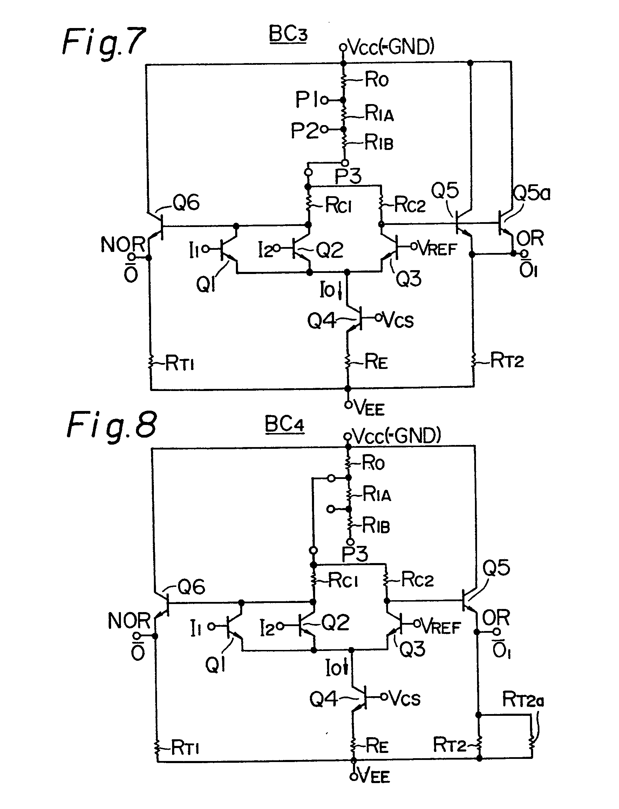

Figure 7 shows another basic cell for use in an ECL gate array embodying the present invention. In Figure 7, two output transistors Q5 and Q5a are connected in parallel. As described above with reference to Figures 2 and 3, the provision of an additional transistor Q5a causes the output logic levels to be increased. Therefore, in order to compensate for the increased low logic level, the third selecting terminal P3 is connected to the common connecting terminal P4.

Figure 8 shows a further basic cell for use in an ECL gate array embodying the present invention. In Figure 8, two output resistors $R_{T2}$ and $R_{T2a}$ are connected in parallel. As described above, the provision of an additional transistor $R_{T2a}$ causes the output logic levels to be decreased. Therefore, to compensate for the decreased high logic level, the first selecting terminal P1 is connected to the common connecting terminal P4.

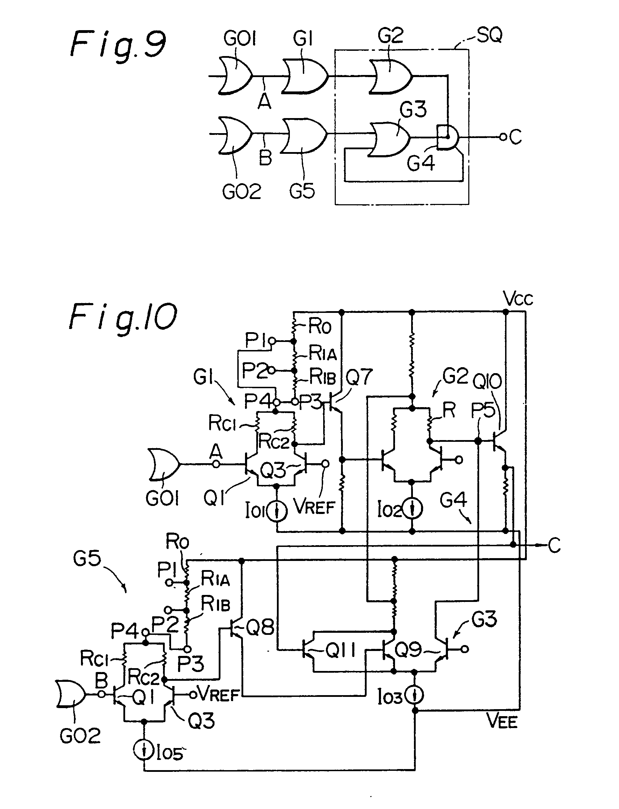

Figure 9 shows a logic circuit including a sequential circuit in an ECL gate array embodying the present invention. In Figure 9, peripheral OR gates G01 and G02 are connected to input OR gates G1 and G5, respectively. The input OR gates G1 and G5 are connected to a sequential circuit SQ. The sequential circuit SQ includes OR gates G2 and G3, and an AND gate G4. The outputs of the OR gates G1 and G5 are connected respectively to the inputs of the OR gates G2 and G3. The outputs of the OR gates G2 and G3 are connected to the inputs of the AND gate G4. The output of the AND gate G4 is connected to another input of the OR gate G3 and to an output end C. These gates G01, G02, and G1 through G5 are realized by the basic cells shown in Figure 5. The truth table explaining the relationship between inputs A and B applied to the OR gates G1 and G5 and the output C is as shown below:

TRUTH TABLE

| A | B | $C_{n+1}$ |
|---|---|-----------|
| H | H | H |
| H | L | Cn |
| L | H | L |
| L | L | L |

where $C_{n+1}$ represents a current logic level of the output C, and Cn represents an immediately preceding logic level of the output C.

As will be seen from the above table, if the input B is changed to the low logic level from a state wherein both of the inputs A and B are at the high logic level H, so that the output C is also at the high logic level H, the output C is Cn which is the same as the immediately preceding output logic level, i.e., the high logic level H. However, if a noise is applied instantaneously so that the input A turns instantaneously to the low logic level L, the output C also turns to the low logic level. From this state, even after the noise is removed and the input A recovered to the high logic level H, the output C remains at the low logic level L. Therefore, the output C is erroneously turned from the high logic level H to the low logic level L even after the noise is removed. To recover the output C to the high logic level H, both inputs A and B should be turned to the high logic level H.

Similarly, where the input A is H, the input B is L, and the output C is L, when the input B turns instantaneously to H and again recovers to L, the output C level is changed from L to H even after the recovery of the input B.

Therefore, according to an embodiment of the present invention, the high logic level of the output of the input OR gate G1 is raised to increase the noise margin of the high logic level, and the low logic level of the output of the input OR gate G5 is lowered to increase the noise margin of the low logic level.

Figure 10 shows a detailed circuit diagram of the circuit shown in Figure 9. In Figure 10, the output high logic level of the input OR gate G1 is raised by connecting the first selecting terminal P1 of that gate to the common connecting terminal P4 thereof. Also, the output low logic level of the input OR gate G5 is lowered by connecting the third selecting terminal P3 of that gate to the common connecting terminal P4 thereof. An emitter follower transistor Q7 of the gate G1 operates to send the output of the OR gate G1 to the input of the OR gate G2, and an emitter follower transistor Q8 of the gate G5 operates to send the output of the OR gate G5 to the input of the OR gate G3. The AND gate G4 is realized by connecting the collector of a transitor Q9 in the OR gate G3 to the output point P5 of the OR gate G2. That is, the AND gate G4 is a collector dot AND gate. The emitter of a transistor Q10 is connected to the output end C and to the base of an input transistor Q11 in the OR gate G3. The constitutions of the OR gates G2 and G3 are well known and, therefore, are not described here. $I_{01}$, $I_{02}$, $I_{03}$, and $I_{05}$ are constant current sources of the OR gates G1, G2, G3, and G5, respectively.

In the foregoing embodiments, the resistors $R_0$, $R_{1A}$, and $R_{1B}$ are previously connected in series before selecting one of the selecting terminals to be connected to the terminal P4. The present invention, however, is not restricted to this arrangement.

In particular, instead of connecting the resistors $R_0$, $R_{1A}$, and $R_{1B}$ in series, resistors $R_{00}$, $R_{1A0}$, and $R_{1B0}$ may be arranged without wiring in parallel before determining the circuit design.

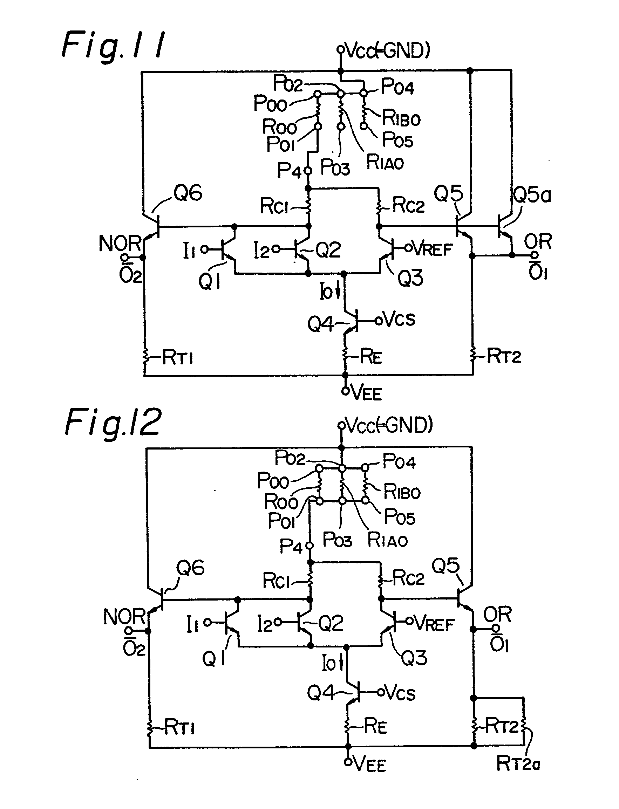

Figure 11 shows the resistors $R_{00}$, $R_{1A0}$, and $R_{1B0}$ in yet another basic cell embodying the present invention. In Figure 11, the resistors $R_{00}$, $R_{1A0}$, and $R_{1B0}$ are connected between terminals $P_{00}$ and $P_{01}$, $P_{02}$ and $P_{03}$, and $P_{04}$ and $P_{05}$, respectively. The terminals $P_{00}$, $P_{02}$, and $P_{04}$ are connected to the power supply line $V_{CC}$. The terminals $P_{01}$, $P_{03}$, and $P_{05}$ are the selecting terminals. Since in Figure 11 two output transistors Q5 and Q5a are connected in parallel, as in the embodiment shown in Figure 7, the common collector load should have a higher resistance value. Therefore, the selecting terminals $P_{03}$ and $P_{05}$ are not connected to any terminal, and only the selecting terminal $P_{01}$ is connected to the common connecting terminal P4. Thus, only the resistor $R_{00}$ is connected between the common connecting terminal P4 and the power supply line $V_{CC}$.

Figure 12 shows an application of the connection of the resistors $R_{00}$, $R_{1A0}$, and $R_{1B0}$ in still another basic cell embodying the present invention. In Figure 12, since the two output resistors $R_{T2}$ and $R_{T2a}$ are connected in parallel, as in the embodiment shown in Figure 8, the common collector load should have a lower resistance value. Therefore, the selecting terminals $P_{01}$, $P_{03}$, and $P_{05}$ are connected to the terminal P4, to realize the smallest common collector resistance, i.e., $R_{00} \cdot R_{1A0} \cdot R_{1B0}/(R_{1A0} \quad R_{1B0}+R_{00} \quad R_{1A0}+R_{00} \cdot R_{1B0})$, where $R_{00}$, $R_{1A0}$, and $R_{1B0}$ also represent the resistance values. In Figures 11 and 12, the resistance $R_{00}$ is smaller than the resistance $R_{1A0}$ or $R_{1B0}$.

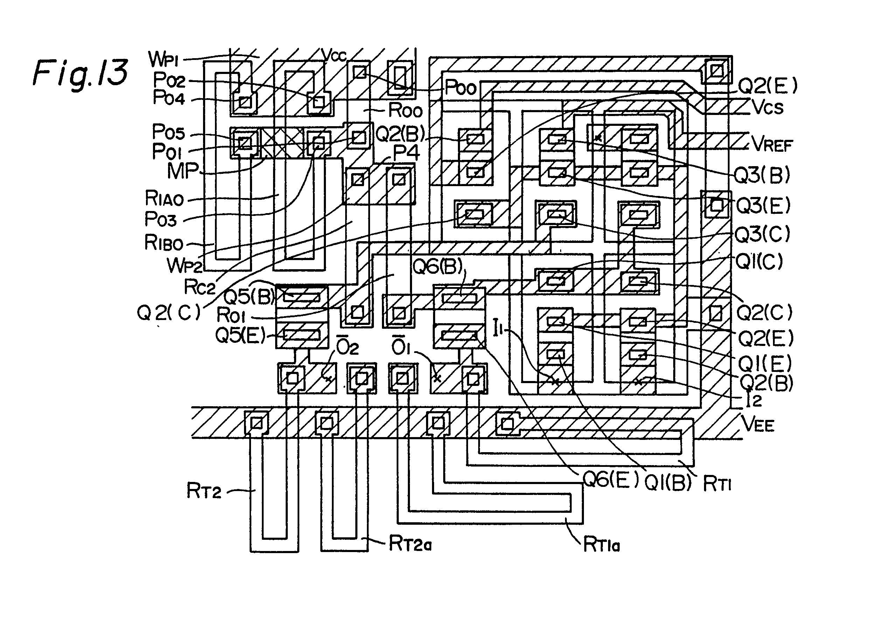

Figure 13 is a plan view illustrating a wiring pattern in the basic cell shown in Figure 12. In Figure 13, the selecting terminals $P_{00}$, $P_{01}$, $P_{02}$, $P_{03}$, $P_{04}$, and $P_{05}$, and the common connecting terminals $P_4$, are formed as contact windows. The resistances $R_{00}$, $R_{1A0}$, and $R_{1B0}$ are formed by a diffusion layer. The selecting terminals $P_{00}$, $P_{02}$, and $P_{04}$ are in contact with, and covered by, a wiring layer $W_{P1}$ for the power supply line $V_{CC}$. The selecting terminals $P_{01}$, $P_{03}$, and $P_{05}$, and the common connecting terminals P4, are in contact with and are covered by, another wiring layer $W_{P2}$. The wiring layers $W_{P1}$ and $W_{P2}$ are formed by a metal layer in accordance with a desired wiring pattern. That is, an appropriate mask for patterning the wirings is previously formed in accordance with the desired wiring pattern. For example, when the selecting terminal $P_{05}$ should not be connected, a mask pattern MP between the terminals $P_{03}$ and $P_{05}$, as illustrated by mesh in the Figure, is removed so that no wiring is provided between them. In the Figure, the slash line portions represent wirings formed by the metal layers. Reference symbols Q1(C), Q1(E), and Q1(B), respectively, represent the collector contact, the emitter contact, and the base contact of the input transistor Q1. Similar symbols indicate respective contacts of the transistors Q2, Q3, Q5 and Q6. Each symbol X in the figure represents a throughhole for connection to the upper or lower wiring layer. Therefore, the input ends $I_1$ and $I_2$, and the output ends $\bar{O}_1$ and $\bar{O}_2$, are connected by throughholes to the other wiring layer.

From the foregoing description, it will be apparent that, according to the present invention, each basic cell in an ECL gate array can output the desired logic levels, without decreasing or increasing the logic swing of the output logic levels, and therefore, the noise margin can be increased without deteriorating the switching speed of the basic cell.

The present invention is not restricted to the described embodiments. Various changes and modifications are possible without departing the scope of the invention. For example, the number of the common collector resistors may be two or more.

## Claims

1. An ECL gate array comprising a plurality of basic cells ($BC_1$, $BC_2$) arranged in a matrix and each connected between first and second power supply lines ($V_{CC}$, $V_{EE}$), each of the said basic cells ($BC_1$, $BC_2$) comprising at least a pair of emitter-coupled transistors (Q2, Q3), a load ($R_0$, $R_{C1}$, $R_{C2}$) connected between respective collectors of the transistor pair (Q2, Q3) and the first power supply line ($V_{CC}$), current source means (Q4, $R_E$) connected between the coupled emitters of the said transistor pair (Q2, Q3) and the said second power supply line ($V_{EE}$), and an output node connected to the collector of one of the said transistors (Q2, Q3) of the said pair; the said basic cells ($BC_1$, $BC_2$) of the said plurality being connected together in accordance with a desired wiring pattern, and the said load ($R_0$, $R_{C1}$, $R_{C2}$) comprising a first load resistor ($R_{C1}$) connected between the collector of one of the said transistors (Q2) and a common node (A; P4), a second load resistor ($R_{C2}$) connected between the collector of the other of the said transistors (Q3) and the said common node (A; P4), and resistance means ($R_0$) connected between the said common node (A; P4) and the said first power supply line ($V_{CC}$); characterised in that in each basic cell ($BC_1$, $BC_2$) the said resistance means comprises a group of level-shifting resistors ($R_0$, $R_{1A}$, $R_{1B}$) which have been selected from a plurality of level-shifting resistors provided in the cell concerned and are connected together to provide a desired load in accordance with the said wiring pattern, and in that the current source means (Q4, $R_E$) of at least one basic cell ($BC_1$) in the array provide substantially the same current as the current source means (Q4, $R_E$) of another of the said basic cells ($BC_2$), the said group of level-shifting resistors ($R_0$, $R_{1A}$, $R_{1B}$) in the said one basic cell ($BC_1$) being chosen in such a way that the load provided thereby differs from that of the said another basic cell ($BC_2$), thereby to ensure that the amplitude of an output signal appearing at the said output node of the said one basic cell ($BC_1$) is substantially equal to the amplitude of an output signal appearing at the output node of the said another basic cell ($BC_2$).

2. An array as claimed in Claim 1, wherein each of the said basic cells ($BC_1$, $BC_2$) further comprises a plurality of selecting terminals (P1, P2, P3) connected to respective ends of the said level-shifting resistors ($R_0$, $R_{1A}$, $R_{1B}$), wherein the said common node (P4) is connected to at least one of the said connecting terminals (P1, P2, P3) so as to obtain the desired load.

3. An array as claimed in Claim 2, wherin each of the said basic cells ($BC_1$, $BC_2$) further comprises an output transistor (Q5, Q6) and an output terminal ($\bar{O}1$, $\bar{O}2$), the said output transistor (Q5, Q6) having a base connected to the said collector of the said one transistor (Q2, Q3) of the pair, a collector connected to the said first power supply line ($V_{CC}$), and an emitter connected to the said output terminal ($\bar{O}1$, $\bar{O}2$), the said common node (P4) having been connected to at least one of the said selecting terminals (P1, P2, P3) in order to ensure that the voltage levels at the said output terminal ($\bar{O}1$, $\bar{O}2$) are substantially equal to respective desired voltage levels.

4. An array as claimed in Claim 3, wherein some of the said basic cells ($BC_1$, $BC_2$) of the plurality belong either to a first group, or to a second group, or to a third group, of cells, the said one basic cell ($BC_1$) and the said another basic cell ($BC_2$) belonging to different groups, and wherein in each of the basic cells in the said first group the said desired load is such that the voltage drop across the said resistance means ($R_0$, $R_{1A}$, $R_{1B}$) in each cell concerned is equal to a first voltage difference, and wherein in each of the basic cells in the said second group the said desired load is such that the voltage drop across the said resistance means ($R_0$, $R_{1A}$, $R_{1B}$) in each cell concerned is equal to a second voltage difference which is larger than the said first voltage difference, and wherein in each of the basic cells in the said third group the said desired load is such that the voltage drop across the said resistance means ($R_0$, $R_{1A}$, $R_{1B}$) in each cell concerned is equal to a third voltage difference which is smaller than the said first voltage difference; the said first, second and third groups of basic cells being formed in accordance with the said wiring pattern.

5. An array as claimed in Claim 4, wherein at least one of the basic cells ($BC_2$) belonging to the said second group is connected to the said first power supply line ($V_{CC}$) by means of wiring which is longer than that connecting a basic cell of the said first group to that power supply line ($V_{CC}$).

6. An array as claimed in Claim 4, wherein the said second group of basic cells includes a basic cell ($BC_3$) comprising a further output transistor ($Q5_a$) connected in parallel with the said output transisteor ($Q5$) in such a way as to incrase the rising speed of the output voltage signal at the said output terminal ($\bar{O}1$).

7. An array as claimed in Claim 4, wherein each of the said basic cells includes an output resistor ($RT_2$) connected between the emitter of the said output transistor ($Q5$, $Q6$) and the said second power supply line ($V_{EE}$), and wherein the said third group of basic cells includes a basic cell ($BC_4$) comprising a further output resistor ($RT_{2a}$) connected in parallel with the said output resistor ($RT_2$) in such a way as to increase the falling speed of the output voltage signal at the said output terminal ($\bar{O}1$).

8. An array as claimed in any one of Claims 2 to 7, wherein the said level-shifting resistors ($R_0$, $R_{1A}$, $R_{1B}$) of the said plurality are connected together in series.

9. An array as claimed in any one of Claims 2 to 7, wherein respective other ends of the said level-shifting resistors ($R_{00}$, $R_{1A0}$, $R_{1B0}$) of the said plurality are connected together, so that a desired load may be obtained by connecting together two or more such level-shifting resistors in parallel.

**Patentansprüche**

1. ECL-Gate-Array mit einer Vielzahl von Basiszellen ($BC_1$, $BC_2$), die in einer Matrix angeordnet und jeweils zwischen ersten und zweiten Energieversorgungsleitungen ($V_{CC}$, $V_{EE}$) verbunden sind, wobei jede der genannten Basiszellen ($BC_1$, $BC_2$) wenigstens ein Paar von emittergekoppelten Transistoren ($Q2$, $Q3$), eine Last ($R_0$, $R_{C1}$, $R_{C2}$), die zwischen entsprechenden Kollektoren des Transistorpaares ($Q2$, $Q3$) und der ersten Energieversorgungsleitung ($V_{CC}$) verbunden ist, eine Stromquelleneinrichtung ($Q4$, $R_E$), die zwischen den gekoppelten Emittern des genannten Transistorpaares ($Q2$, $Q3$) und der genannten zweiten Energieversorgungsleitung ($V_{EE}$) verbunden ist, und einen Ausgangsknoten, der mit dem Kollektor· von einem der genannten Transistoren ($Q2$, $Q3$) des genannten Paares verbunden ist, umfaßt; welche genannten Basiszellen ($BC_1$, $BC_2$) der genannten Vielzahl miteinander in Übereinstimmung mit einem gewünschten Verdrahtungsmuster verbunden sind, und welche genannte Last ($R_0$, $R_{C1}$, $R_{C2}$) einen ersten Lastwiderstand ($R_{C1}$), der zwischen dem Kollektor von einem der genannten Transistoren ($Q2$) und einem gemeinsamen Knoten (A; P4) verbunden ist, einen zweiten Lastwiderstand ($R_{C2}$), der zwischen dem Kollektor des anderen der genannten Transistoren ($Q3$) und dem genannten gemeinsamen Knoten (A; P4) verbunden ist, und eine Widerstandseinrichtung ($R_0$), die zwischen dem genannten gemeinsamen Knoten (A; P4) und der genannten ersten Energieversorgungsleitung ($V_{CC}$) verbunden ist, umfaßt;

dadurch gekennzeichnet, daß jede Basiszelle ($BC_1$, $BC_2$) der genannten Widerstandseinrichtung eine Gruppe von Pegelschiebewiederständen ($R_0$, $R_{1A}$, $R_{1B}$) umfaßt, die aus einer Vielzahl von Pegelschiebewiderständen ausgewählt sind, die in der betreffenden Zelle vorgesehen und miteinander verbunden sind, um eine gewünschte Last in Übereinstimmung mit dem genannten Verdrahtungsmuster zu bilden, und daß die Stromquelleneinrichtung ($Q4$, $R_E$) von mindestens einer Basiszelle ($BC_1$) in der Anordnung im wesentlichen denselben Strom wie die Stromquelleneinrichtung ($Q4$, RE) von einer anderen der genannten Basiszellen ($BC_2$) liefert, die genannte Gruppe von Pegelschiebewiederständen ($R_0$, $R_{1A}$, $R_{1B}$) in der genannten einen Basiszelle ($BC_1$) auf solch eine Weise gewählt sind, daß die Last, die durch sie gebildet wird, sich von jener der anderen Basiszellen ($BC_2$) unterscheidet, um dadurch zu gewährleisten, daß die Amplitude von einem Ausgangssignal, das an dem Ausgangsknoten von der genannten einen Basiszelle ($BC_1$) erscheint, im wesentlichen gleich der Amplitude von einem Ausgangssignal ist, welches an dem Ausgangsknoten der genannten anderen Basiszelle ($BC_2$) erscheint.

2. Array nach Anspruch 1, bei dem jede der genannten Basiszellen ($BC_1$, $BC_2$) ferner eine Vielzahl von auswählenden Anschlüssen (P1, P2, P3) umfaßt, die mit entsprechenden Ende der genannten Pegelschiebewiderstände ($R_0$, $R_{1A}$, $R_{1B}$) verbunden sind, wobei der genannte ersten Knoten (P4) mit wenigstens einem der genannten Verbindungsanschlüsse (P1, P2, P3) verbunden ist, um so die gewünschte Last zu erhalten.

3. Array nach Anspruch 2, bei dem jede der genannten Basiszellen ($BC_1$, $BC_2$) ferner einen Ausgnagstransistor ($Q5$, $Q6$) und einen Ausgangsanschluß ($\bar{O}1$, $\bar{O}2$) umfaßt, der genannte Ausgangstransistor ($Q5$, $Q6$) eine Basis hat, die mit dem genannten Kollektor von dem genannten einen Transistor ($Q2$, $Q3$) des Paares verbunden ist, ein Kollektor mit der genannten ersten Energievorsgungsleitung ($V_{CC}$) verbunden ist, und ein Emitter mit dem genannten Ausgangsanschluß ($\bar{O}1$, $\bar{O}2$) des genannten gemeinsamen Knotens (P4) verbunden ist, der mit wenigstens einem der genannten auswählenden Anschlüsse (P1, P2, P3) verbunden worden ist, um zu gewährleisten, daß die Spannungspegel an den genannten Ausgangsanschlüssen ($\bar{O}1$, $\bar{O}2$) im wesentlichen gleich den jeweils gewünschten Spannungspegeln sind.

4. Array nach Anspruch 3, bei dem einige der genannten Basiszellen ($BC_1$, $BC_2$) der Vielzahl entweder zu einer ersten oder zu einer zweiten oder zu einer dritten Gruppe von Zellen gehört, die genannte eine Basiszelle ($BC_1$) und die genannte andere Basiszelle ($BC_2$) zu verschiedenen Gruppen gehören, und bei dem in jeder der Basiszellen in der genannten ersten Gruppe die genannte gewünschte Last so iste, daß der Spannungsabfall an der genannten Widerstandseinrichtung ($R_0$, $R_{1A}$, $R_{1B}$) in jeder betreffenden Zelle gleich einer ersten Spannungsdifferenz ist, und bei dem in jeder der Basiszellen in der genannten zweiten Gruppe die genannte gewünschte Last so ist, daß der Spannungsabfall an der genannten Widerstandseinrichtung ($R_0$, $R_{1A}$, $R_{1B}$) in jeder betreffenden Zelle gleich einer zweiten Spannungsdifferenz ist, die größer als die genannte erste Spannungsdifferenz ist, und bei der in jeder der Basiszellen in der genannten dritten Gruppe die genannte gewünschte Last so ist, daß der Spannungsabfall an der genannten Widerstandseinrichtung ($R_0$, $R_{1A}$, $R_{1B}$) in jeder betreffenden Zelle gleich einer dritten Spannungsdifferenz ist, die kleiner als die genannte erste Spannungsdifferenz ist; wobei die genannte erste, zweite und dritte Gruppe von Basiszellen in Übereinstimmung mit dem genannten Verdrahtungsmuster gebildet sind.

5. Array nach Anspruch 4, bei dem wenigstens eine der Basiszellen ($BC_2$), die zu der genannten zweiten Gruppe gehört, mit der genannten ersten Energieversorgungsleitung ($V_{CC}$) über eine Verdrahtung verbunden ist, die länger als diejenige ist, welche eine Basiszelle der genannten ersten Gruppe mit jener Energieversorgungsleitung ($V_{CC}$) verbindet.

6. Array nach Anspruch 4, bei dem die genannte zweite Gruppe von Basiszellen eine Basiszelle ($BC_3$) enthält, die einen weiteren Ausgangstransistor ($Q5a$) umfaßt, der parallel mit dem genannten Ausgangstransistor ($Q5$) in solch einer Weise verbunden ist, daß die Anstiegsgeschwindigkeit des Ausgangsspannungssignals an dem genannten Ausgangsanschluß ($\overline{O}1$) erhöht wird.

7. Array nach Anspruch 4, bei dem jede der genannten Basiszellen einen Ausgangswiderstand ($RT_2$) enthält, der zwischen dem Emiter des genannten Ausgangstransistors ($Q5$, $Q6$) und der genannten zweiten Energieversorgungsleitung ($V_{EE}$) verbunden ist, und bei dem die genannte dritte Gruppe von Basiszellen eine Basiszelle ($BC4$) enthält, die einen weiteren Ausgangswiderstand ($RT_{2a}$) umfaßt, der parallel mit dem genannten Ausgangswiderstand ($RT_2$) in solch einer Weise verbunden ist, daß die Abfallgeschwindigkeit des Ausgangsspannungssignals an dem genannten Ausgangsanschluß ($\overline{O}1$) erhöht wird.

8. Array nach einem der Ansprüche 2 bis 7, bei dem die genannten Pegelschiebewiderstände ($R_0$, $R_{1A}$, $R_{1B}$) der genannten Vielzahl miteinander in Reihe verbunden sind.

9. Array nach einem der Ansprüche 2 bis 7, bei dem jeweils andere Enden der genannten Pegelschiebewiderstände ($R_{00}$, $R_{1A0}$, $R_{1B0}$) der genannten Vielzahl so miteinander verbunden sind, daß durch Verbinden von zwei oder mehr solchen Pegelwiderständen parallel zueinander eine gewünschte Last erhalten werden kann.

## Revendications

1. Réseau de portes ECL comprenant plusieurs cellules de base ($BC_1$, $BC_2$) disposées en une matrice et connectées chacune entre une première et une seconde lignes d'alimentation ($V_{CC}$, $V_{EE}$), chacune desdites cellules de base ($BC_1$, $BC_2$) comprenant au moins une paire de transistors à émetteurs couplés ($Q2$, $Q3$), une charge ($R_0$, $R_{C1}$, $R_{C2}$) connectée entre les collecteurs respectifs des transistors de la paire ($Q2$, $Q3$) et la première ligne d'alimentation ($V_{CC}$), une source de courant ($Q4$, $R_E$) connectée entre les émetteurs couplés desdits transistors de la paire ($Q2$, $Q3$) et ladite seconde ligne d'alimentation ($V_{EE}$) et un point commun de sortie connecté au collecteur de l'un desdits transistors ($Q2$, $Q3$) de ladite paire, lesdites cellules de base ($BC_1$, $BC_2$) parmi lesdites plusieurs étant connectées ensemble en fonction d'une configuration de connexion voulue, et ladite charge ($R_0$, $T_{C1}$, $R_{C2}$) comprenant une première résistance de charge ($R_{C1}$) connectée entre le collecteur de l'un desdits transistors ($Q2$) et un point commun ($A$; $P4$), une seconde résistance de charge ($R_{C2}$) connectée entre le collecteur de l'autre desdits transistors ($Q3$) et ledit point commun ($A$; $P4$) et des résistances connectées entre ledit point commun ($A$; $P4$) et ladite première ligne d'alimentation ($V_{CC}$);

caractérisé en ce que, dans chaque cellule de base ($BC_1$, $BC_2$), lesdites résistances consistent en un groupe de résistances de décalage de niveau ($R_0$, $R_{1A}$, $R_{2B}$) qui ont été choisies parmi plusieurs résistances de décalage de niveau prévues dans la cellule concernée et qui sont connectées ensemble pour présenter une charge voulue en fonction de ladite configuration de connexion et en ce que la source de courant ($Q4$, $R_E$), d'au moins une cellule de base ($BC_1$) du réseau produit pratiquement le même courant que la source de courant ($Q4$, $R_E$) d'une autre desdites cellules de base ($BC_2$), ledit groupe de résistance de décalage de niveau ($R_0$, $R_{1A}$, $R_{1B}$) de ladite première cellule de base ($BC_1$) étant choisi de manière que la charge présentée diffère donc de celle de ladite autre cellule de base ($BC_2$) de manière à assurer que l'amplitude d'un signal de sortie apparaissant audit point commun de sortie de ladite première cellule de base ($BC_1$) soit pratiquement égale à l'amplitude du signal de sortie apparaissant au point commun de sortie de ladite autre cellule de base ($BC_2$).

2. Réseau selon la revendication 1, dans lequel chacune desdites cellules de base ($BC_1$, $BC_2$) comporte en outre plusieurs bornes de sélection ($P1$, $P2$, $P3$) connectées aux extrémités respectives desdites résistances de décalage de niveau ($R_0$, $R_{1A}$, $R_{1B}$), dans lequel ledit point commun ($P4$) este connecté à l'une au moins desdites bornes de connexion ($P1$, $P2$, $P3$) de manière à obtenir la charge voulue.

3. Réseau selon la revendication 2, dans lequel chacune desdites cellules de base ($BC_1$, $BC_2$) comporte en outre un transistor de sortie ($Q5$, $Q6$) et une borne de sortie ($\overline{O}1$, $\overline{O}2$), ledit transistor de sortie ($Q5$, $Q6$) comportant une base connectée audit collecteur dudit premier transistor ($Q2$, $Q3$) de la paire, un collecteur connecté à ladite première ligne d'alimentation ($V_{CC}$) et un émetteur connecté à ladite borne de sortie ($\overline{O}1$, $\overline{O}2$), ledit point commun ($P4$) ayant été connecté à l'une au moins desdites bornes de sélection ($P1$, $P2$, $P3$) afin d'assurer que les niveaux de tension à ladite

borne de sortie ($\overline{O}1$, $\overline{O}2$) soient pratiquement égaux aux niveaux respectifs de tension voloue.

4. Réseau selon la revendication 3, dans lequel certaines desdites cellules de base ($BC_1$, $BC_2$) parmi les plusieurs appartiennent à un premier groupe, ou à un second group ou à un troisième groupe de cellules, ladite première cellule de base ($BC_1$) et ladite autre cellule de base ($BC_2$) appartenant à des groupes différents et dans lequel, dans chacune des cellules de base dudit premier groupe, ladite charge voulue est telle que la chute de tension aux bornes desdites résistances ($R_0$, $R_{1A}$, $R_{1B}$) dans chaque cellule concernée est égale à une première différence de tension et dans lequel, dans chacune des cellules de base dudit second groupe, ladite charge voulue est telle que la chute de tension aux bornes desdites résistances ($R_0$, $R_{1A}$, $R_{1B}$) de chaque cellule concernée soit égale à une seconde différence de tension qui est supérieure à ladite première différence de tension et dans lequel, dans chacune des cellules de base dudit troisième groupe, ladite charge voulue est telle que la chute de tension aux bornes desdites résistances ($R_0$, $R_{1A}$, $R_{1B}$) de chaque cellule concernée soit égale à une troisième différence de tension qui est inférieure à ladite première différence de tension; ledit premier, ledit second et ledit troisième groupes de cellules de base étant formés en fonction de ladite configuration de connexion.

5. Réseau selon la revendication 4, dans lequel l'une au moins des cellules de base ($BC_2$) appartenant audit second groupe est connectée à ladite première ligne d'alimentation ($V_{cc}$) par l'intermédiaire d'une connexion qui est plus longue que celle qui connecte une cellule de base dudit premier groupe à ladite ligne d'alimentation ($V_{cc}$).

6. Réseau selon la revendication 4, dans lequel ledit second groupe de cellules de base contient une cellule de base ($BC_3$) comportant une autre transistor de sortie ($Q5a$) connectée en parallèle avec ledit transistor de sortie ($Q5$) de manière à augmenter la vitesse d'augmentation du signal de tension de sortie à ladite borne de sortie ($\overline{O}1$).

7. Réseau selon la revendication 4, dans lequel chacune desdites cellules de base comporte une résistance de sortie ($RT_2$) connectée entre l'émetteur dudit transistor de sortie ($Q5$, $Q6$) et ladite seconde ligne d'alimentation ($V_{EE}$) et dans lequel ledit troisième groupe de cellules de base comporte une cellule de base ($BC_4$) comprenant une autre résistance de sortie ($RT_{2a}$) connectée en parallèle avec ladite résistance de sortie ($RT_2$) de manière à augmenter la vitesse de décroissance du signal de tension de sortie à ladite borne de sortie ($\overline{O}1$).

8. Réseau selon l'une quelconque des revendications 2 à 7, dans lequel lesdites résistances de décalage de niveau ($R_0$, $R_{1A}$, $R_{1B}$) parmi lesdites plusieurs sont connectées ensemble en série.

9. Réseau selon l'une quelconque des revendications 2 à 7, dans lequel les autres extrémités respectives desdites résistances de décalage de niveau ($R_{00}$, $R_{1A0}$, $R_{1B0}$) desdites plusieurs sont connectées ensemble de manière qu'une charge voulue puisse être obtenue en connectant ensemble en parallèle deux ou plusieurs de ces résistances de décalage de niveau.

# Fig.1

## Fig.2

## Fig.3

*Fig.4*

*Fig.5*

3

EP 0 144 218 B1

Fig.6

## Fig.7

BC3

## Fig.8

BC4

*Fig.9*

*Fig.10*

*Fig.11*

*Fig.12*

*Fig. 13*